Europäisches Patentamt

European Patent Office

Office européen des brevets

(19)

(11) Numéro de publication : **0 125 948**
**B1**

# (12) FASCICULE DE BREVET EUROPÉEN

(45) Date de publication du fascicule du brevet :
06.07.88

(51) Int. Cl.⁴ : **H 03 K 3/57**, H 01 F 19/08,
H 05 H 7/02

(21) Numéro de dépôt : 84400705.4

(22) Date de dépôt : 10.04.84

(54) **Modulateur de puissance muni d'un transformateur.**

(30) Priorité : 15.04.83 FR 8306223

(43) Date de publication de la demande :
21.11.84 Bulletin 84/47

(45) Mention de la délivrance du brevet :
06.07.88 Bulletin 88/27

(84) Etats contractants désignés :
CH DE GB LI .

(56) Documents cités :
FR-A- 1 402 435
US-A- 3 119 968
US-A- 3 590 279
INSTRUMENTS AND EXPERIMENTAL TECHNIQUES,
vol. 24, no. 3, partie 1, mai-juin 1981, pages 690-692,
Plenum Publishing Corp., New York, US; S.S. VDOVIN:
"High-power high-voltage pulse transformer"

(73) Titulaire : C.G.R. MeV
Route de Guyancourt
F-78530 Buc (FR)

(72) Inventeur : Aucouturier, Jeanne
THOMSON-CSF SCPI 173, bld. Haussmann
F-75379 PARIS CEDEX 08 (FR)
Inventeur : Leboutet, Hubert
THOMSON-CSF SCPI 173, bld. Haussmann
F-75379 PARIS CEDEX 08 (FR)
Inventeur : Pourre, Jean-Louis
THOMSON-CSF SCPI 173, bld. Haussmann
F-75379 PARIS CEDEX 08 (FR)

(74) Mandataire : Grynwald, Albert et al
THOMSON-CSF SCPI 19, avenue de Messine
F-75008 Paris (FR)

EP 0 125 948 B1

Jouve, 18, rue St-Denis, 75001 Paris, France

## Description

L'invention concerne un modulateur de puissance muni d'un transformateur utilisé notamment pour alimenter en énergie électromagnétique les cavités résonnantes d'un accélérateur linéaire.

Dans un accélérateur linéaire des électrons émis par un canon traversent un ensemble de cavités électromagnétiques. Lors de leur passage dans ces cavités, ils sont accélérés par le champ électromagnétique qui y existe. A la sortie de ces cavités ces électrons viennent frapper à grande vitesse une cible qui à son tour émet d'autres particules. Ces dernières particules sont alors employées dans des applications industrielles d'irradiation ou dans des applications de radiothérapie selon des méthodes connues. La caractéristique principale de ces dernières particules est leur énergie liée à l'énergie des électrons incidents.

Pour conférer une grande énergie aux électrons incidents il est nécessaire que le champ électromagnétique qui règne dans les cavités soit intense. Pour des raisons tant technologiques que d'utilisation le fonctionnement d'un accélérateur linéaire est de type impulsionnel. Ceci signifie que le champ électromagnétique est établi dans les cavités pendant des durées courtes, par exemple de quelques nanosecondes à plusieurs centaines de microsecondes et avec une certaine périodicité, par exemple de 25 Hertz à 1 000 Hertz.

L'établissement du champ électromagnétique dans les cavités est obtenu par couplage inductif ou capacitif de ces cavités à un tube électronique. Pour des fréquences de fonctionnement inférieures à quelques centaines de Mégahertz, le tube électronique utilisé est en général une triode. En fonctionnement, lors de l'apparition d'une très haute tension continue entre la cathode et l'anode de ce tube, celui-ci émet un champ électromagnétique entre ses électrodes. La fréquence d'oscillation de ce champ est imposée par les formes et dimensions des cavités.

Dans l'état actuel de la technique la très haute tension appliquée entre cathode et anode du tube triode, couramment de l'ordre de plusieurs dizaines de kilovolts, est obtenue en élevant, par un transformateur d'impulsions de rapport de transformation inférieur à 20, la tension d'impulsions produites par un étage haute tension. L'étage haute tension doit donc ainsi délivrer des impulsions d'amplitude supérieure à plusieurs milliers de volts. La réalisation de cet étage haute tension est coûteuse.

Dans l'invention un modulateur de puissance, remplissant les fonctions assurées par l'étage haute tension et le transformateur d'impulsions, résout ces problèmes en remplaçant tout cet ensemble par un transformateur d'impulsions unique de rapport de transformation élevé. De telles réalisations sont par ailleurs décrites dans un brevet français FR-1 402 435 et dans l'article « High-Power High-Voltage Pulse Transformer » de Monsieur S. S. Vdovin publié par Instruments and Experimental Techniques, vol. 24, n° 3, partie 1, Mai-Juin 1981, pages 690 à 692. Cependant ce type de solution rencontre des difficultés de mise en œuvre qui ont jusqu'ici toujours été un obstacle à son adoption. En effet, la réalisation d'un transformateur de rapport de transformation élevé se heurte essentiellement à un problème : celui de réduire les forces contre-électromotrices produites du fait de la présence des inductances de fuite. En effet si le rapport de transformation est élevé, les forces contre-électromotrices, proportionnelles à L (dI/dt), sont d'autant plus grandes que le dI/dt est plus grand. C'est exactement ce qui se produit quand le rapport de transformation est élevé puisque dans ce cas le courant primaire est très grand. L'invention donne une solution à ce problème.

L'invention concerne un modulateur de puissance muni d'un transformateur pour recevoir des impulsions électriques élaborées par un étage générateur d'impulsions et pour produire des impulsions électriques de tension plus élevée, ledit transformateur étant du type cuirassé et comportant un certain nombre d'enroulements primaires raccordés en parallèle à l'étage générateur d'impulsions, ces enroulements primaires étant bobinés autour de l'enroulement secondaire de ce transformateur, caractérisé en ce que les roulements primaires sont raccordés à des plots de distribution par des brins conducteurs rapprochés pour réduire les pertes inductives.

L'invention sera mieux comprise au cours de la description qui suit et à l'examen des figures qui la soutiennent, celles-ci sont données à titre indicatif et non limitatif des caractéristiques de l'invention. Sur ces figures les mêmes repères désignent les mêmes éléments. Elles représentent :

— figure 1, le schéma synoptique du modulateur de l'invention ;

— figure 2, une vue en perspective du circuit magnétique du transformateur de l'invention ;

— figure 3A à 3C, les particularités de bobinage et de raccordement des enroulements primaires de ce transformateur ;

— figure 4, une vue en perspective des différentes parties du modulateur de l'invention ;

— figure 5, une vue en perspective d'une partie des lignes à retard utilisées pour alimenter le transformateur ;

— figure 6, un diagramme temporel des signaux de commande du modulateur.

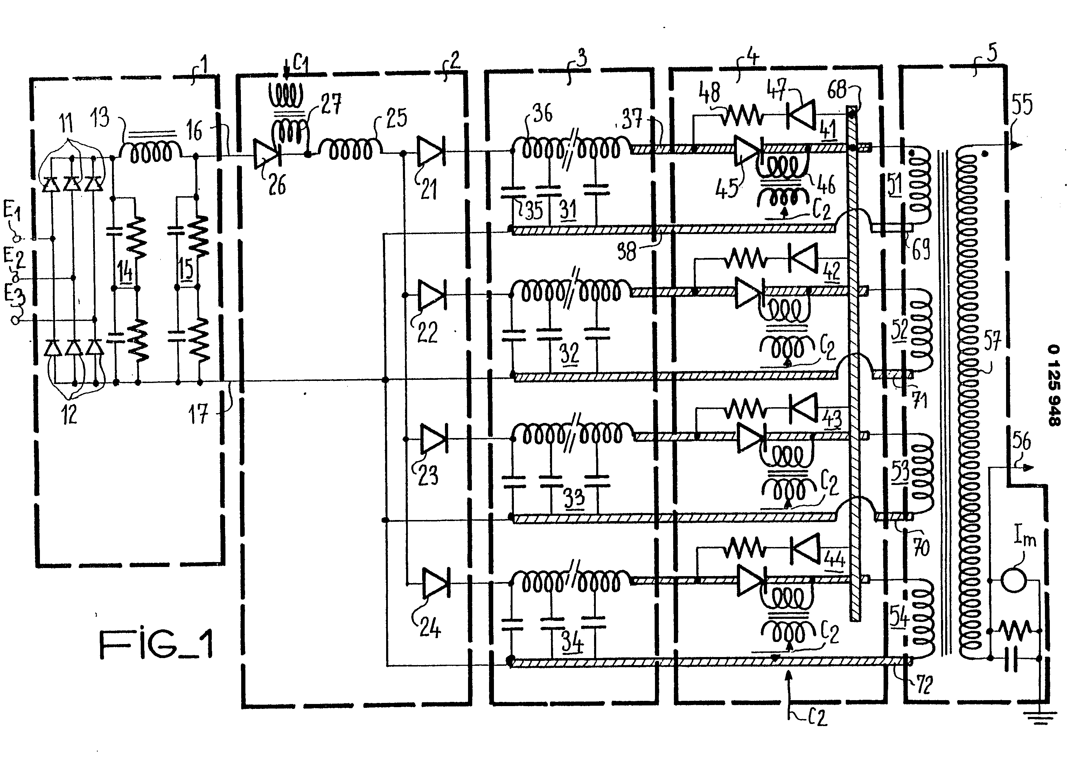

La figure 1 représente le schéma synoptique du modulateur de l'invention. Un circuit de redressement 1 de la tension électrique alternative délivrée en basse tension par le secteur est relié à un circuit 2 de charge d'un ensemble 3 de lignes à retard. Cet ensemble 3 est relié à un étage 4 commutateur d'impulsions lui-même connecté au transformateur 5 de l'invention. Dans l'exemple représenté l'étage 4 comporte quatre commutateurs d'impulsions numérotés 41 à 44, alimentés chacun par une ligne à retard respectivement notée 31 à 34, et raccordés chacun respectivement à un des circuits primaires du transformateur 5 notés 51 à 54. Le circuit 2, l'ensemble 3 et l'étage 4 constituent un étage générateur d'impulsions.

Le circuit de redressement 1 connu dans l'état de la technique, comporte un ensemble de thyristors 11 et de thyristors 12 pour redresser la tension alternative triphasée introduite sur ses entrées E1, E2, E3. Il comporte en outre un circuit de filtrage en $\pi$ où une inductance de lissage 13 est montée en cascade entre deux quadripoles capacité-résistance 14 et 15. Dans un exemple le secteur triphasé est un secteur 380 Volts, et la sortie du circuit de redressement 1 délivre une basse tension continue de l'ordre de 500 volts entre ses bornes 16 et 17.

Le circuit de charge 2 des lignes à retard comporte essentiellement un ensemble de diodes doubleuses numérotées 21 à 24 dont les anodes sont toutes reliées ensemble à une inductance doubleuse 25. Ce montage, d'un type connu, a pour objet de charger les lignes à retard de l'ensemble 3 avec une tension double de celle délivrée par le circuit de redressement 1. les raisons de ce doublement seront vues dans l'explication du fonctionnement des lignes à retard de l'ensemble 3. Par ailleurs le circuit de charge 2 comporte un thyristor 26 connecté à l'autre borne de l'inductance 25 et ayant pour objet de n'autoriser le chargement des lignes à retard 3 que lorsque les commutateurs d'impulsions de l'étage 4 auront été désactivés. Ce thyristor 26 est alors commandé par une commande impulsionnelle C1 appliquée sur la commande 27. La synchronisation de la commande C1 avec la commande C2 d'activation des commutateurs d'impulsions de l'étage commutateur d'impulsions 4 sera vue plus loin.

Les commutateurs d'impulsions de l'étage 4 sont alimentés par les lignes à retard de l'ensemble 3. On peut exprimer schématiquement que ces lignes à retard constituent un ballast se chargeant lentement dans les périodes où il n'y a pas d'impulsions et se déchargeant brutalement au moment de la production de ces impulsions. Les lignes à retard comportent ainsi un ensemble de demi-cellules quadripolaires, capacité 35 et inductance 36, mises en cascade. Lors de la charge, les capacités 35 de ces demi-cellules sont portées au double de la tension délivrée par le circuit 1. Elles sont en effet montées en parallèle entre les cathodes des diodes doubleuses du circuit 2 et la borne 17 du circuit de redressement 1. Lors de la décharge l'énergie électrique stockée dans les demi-cellules des lignes à retard se décharge dans les charges rapportées par les enroulements primaires du transformateur 5. L'impédance caractéristique de chacune des lignes à retard de l'ensemble 3 est calculée pour être égale à l'impédance présentée par chacun de ces enroulements primaires. Les lignes à retard de l'ensemble 3 se comportent alors comme des générateurs de tension, débitant dans une charge adaptée, et pour lesquels on sait que le maximum d'énergie transférée se fait à la moitié de la tension de générateur. L'existence des diodes doubleuses et de l'inductance doubleuse trouve ici son explication. Ainsi dans l'exemple où le circuit de redressement 1 délivre une tension continue de 500 volts on retrouve aux bornes des enroulements primaires du transformateur 5 des impulsions d'amplitude 500 volts.

Le nombre des demi-cellules formées par les capacités 35 et les inductances 36 dans chacune des lignes à retard est liée à la forme de l'impulsion que l'on désire obtenir en attaque des primaires du transformateur 5. Dans un exemple, le nombre de ces demi-cellules est égal à 14. Si on appelle L et C les inductances et capacités équivalentes de la ligne à retard, la durée $\tau$ de l'impulsion de décharge de ces lignes est donnée par la formule $\tau = 2\sqrt{L.C}$. Alors que l'impédance caractéristique de cette ligne est donnée par la formule $Zc = \sqrt{l/c}$ où l et c représentent respectivement les valeurs des inductances 36 et les capacités 35. Ces différents termes permettent de calculer les paramètres de la ligne à retard pour l'utilisation désirée.

Dans l'étage commutateur d'impulsions 4, un commutateur d'impulsions élémentaire 41 est raccordé aux conducteurs de sortie 37 et 38 de la ligne à retard correspondante 31. Ce commutateur d'impulsions 41 comporte essentiellement une porte constituée par un thyristor 45 muni de sa commande associée. Cette commande associée, simulée sous la forme d'un transformateur 46 placé entre drain et grille, est attaquée par une impulsion de commande C2. Le fonctionnement de cette porte est le suivant : lors de l'apparition de la commande C2, le thyristor 45 devient passant et la tension disponible sur les conducteurs 37 et 38 de la ligne à retard 31 est appliquée brutalement aux bornes 69 et 68 de l'enroulement primaire 51. Le rôle de la diode en inverse 47 a pour objet de faciliter la désionisation du thyristor 45 après l'impulsion. En cas d'incident au niveau de la charge du transformateur 5 elle a aussi pour but d'éviter que la ligne à retard 31, se mettant à osciller sur elle-même, vienne à claquer. Ceci risque de se produire en particulier lorsque le tube triode, branché en sortie du transformateur 5, se met en court-circuit. Dans ce cas l'impédance de ce court-circuit, ramenée au primaire 51, a pour effet de présenter un court-circuit entre les conducteurs 37 et 38 de la ligne à retard 31 ce qui amène celle-ci à osciller. La diode inverse 47 a alors pour rôle de shunter les alternances négatives se produisant lors de cette oscillation et du même coup d'empêcher une telle oscillation. Un circuit de mesure du courant moyen d'impulsion « Im » permet par ailleurs de couper le modulateur en cas de dépassement d'un seuil de sécurité.

Dans l'exemple présenté le transformateur 5 comporte 4 enroulements primaires 51 à 54. Ces enroulements primaires d'une manière préférée sont remplacés, chacun, par un groupe d'enroulements primaires en parallèle comportant eux- mêmes un certain nombre de spires. Dans un exemple un enroulement primaire est constitué de trois spires, un groupe d'enroulements primaires contient dix enroulements, et le transformateur contient les quatre groupes. Dans ce même exemple le secondaire 57 accessible entre les bornes 55 et 56 comporte 240 spires. Dans l'application ainsi proposée, le rapport de transformation est donc égal à 80 puisqu'il est le résultat de la division du nombre de spires de l'enroulement secondaire (240) par le nombre de spires de l'un quelconque des enroulements primaires (3). Ce rapport de transformation est donc notablement supérieur à 40 cette dernière valeur étant une limite habituellement reconnue pour des transformateurs d'impulsions élévateurs.

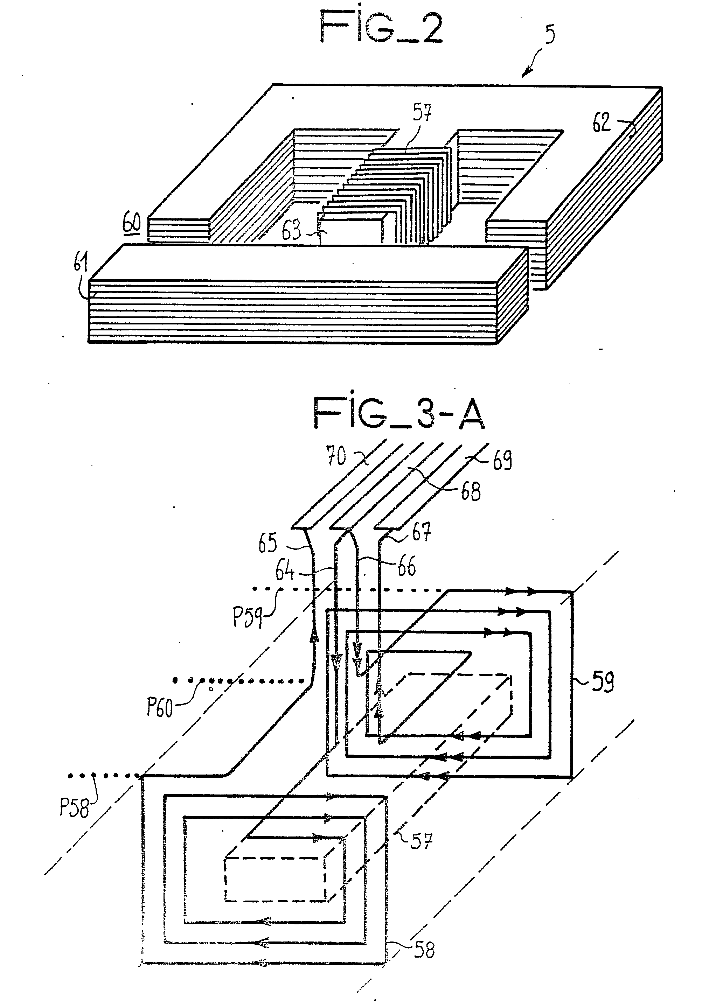

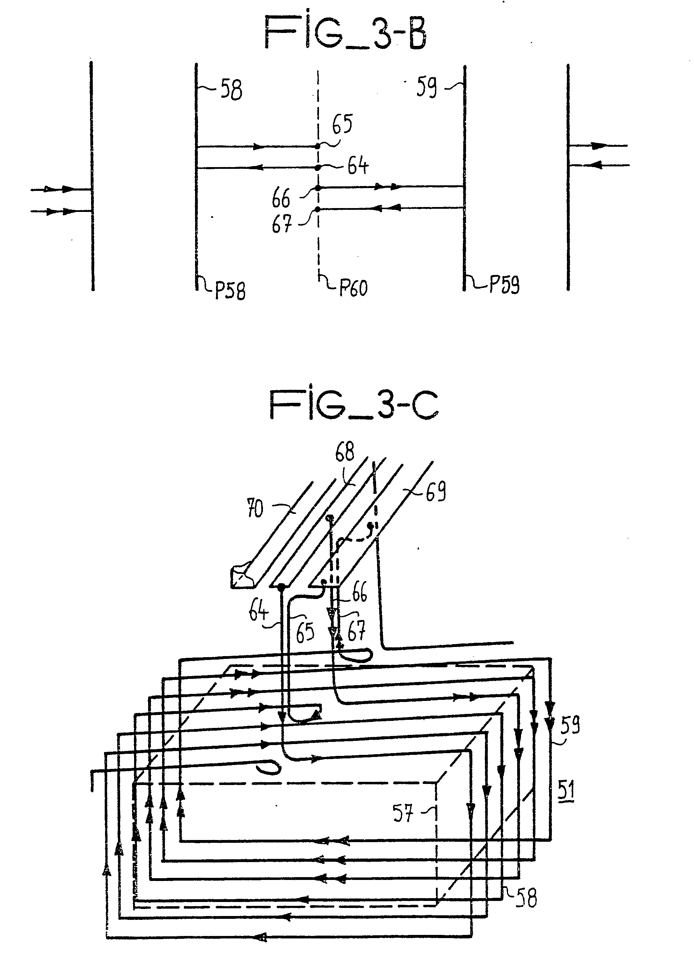

Diverses dispositions auraient pu être choisies pour arriver au même résultat. Il est possible, en particulier, de concevoir un circuit d'alimentation du transformateur 5 avec une seule ligne à retard et un seul commutateur d'impulsions, respectivement 31 et 41, et de brancher tous les enroulements primaires en parallèle sur ce commutateur d'impulsions 41. L'intérêt de la solution de l'invention réside dans le fait que le courant total circulant dans le primaire du transformateur 5 est la somme du courant circulant dans chacun des enroulements primaires. Comme ces enroulements primaires sont nombreux le courant primaire dans chacun d'eux est ainsi d'autant divisé. Le fait de retenir quatre groupes d'enroulements primaires a aussi pour effet de diviser par 4 le courant maximum de passage au travers des thyristors 45. Par ailleurs, la force contre-électromotrice due aux inductances de fuite sera réduite dans le même rapport. Cet avantage est par ailleurs amélioré par une disposition particulière des enroulements primaires sur le transformateur 5 que l'on va étudier maintenant à l'examen des figures 2 et 3.

La figure 2 représente le circuit magnétique 60 du transformateur 5. Le circuit magnétique selon les dispositions connues de l'état de la technique est constitué par un empilement de tôles 61 et 62 découpées en forme de I pour les premières et en forme de E pour les secondes. La fermeture du circuit magnétique 60 s'obtient en venant plaquer l'empilement des tôles 61 sur l'extrémité des jambes de l'empilement des tôles 62. Une autre disposition qui aurait pu être retenue peut consister comme cela est connu en plaquant des empilements de tôles en forme de T contre des empilements de tôles en forme de C. Toute autre réalisation concourant à la réalisation d'un circuit magnétique en forme générale de 8 aurait par ailleurs du point de vue de l'invention des résultats équivalents.

Le transformateur 5 est dit cuirassé car l'enroulement secondaire 57 est bobiné sur la jambe centrale 63 de ce transformateur. Il faut remarquer une particularité du transformateur 5 de l'invention caractérisé par le fait que c'est l'enroulement secondaire 57 qui est bobiné directement sur la jambe centrale 63 du transformateur 5 alors que pour des raisons d'isolation c'est normalement l'enroulement primaire qui est bobiné, dans l'état de la technique, au plus près du circuit magnétique et donc de la jambe centrale 63. L'isolation électrique de l'enroulement secondaire et du circuit magnétique est obtenue par mise en place d'une couche isolante entre cet enroulement et la jambe 63. Cette couche isolante dans un exemple est à base de polychlorure de vinyle et les différents éléments trempent dans de l'huile.

Dans un exemple de réalisation l'enroulement secondaire est réalisé en trois nappes superposées et isolées électriquement. Le déploiement des spires de la première nappe, la plus proche de la jambe 63, s'effectue dans un sens dit « aller » ; celui de la deuxième nappe s'effectue dans un sens inverse dit « retour » et le troisième s'effectue dans le même sens que le premier. Le bobinage est continu d'un bout de l'enroulement secondaire à l'autre et est tel que les contributions magnétiques de ces trois nappes soient toutes orientées dans le même sens.

Sur la figure 3A on distingue des particularités de bobinage des enroulements primaires du transformateur. Pour ne pas surcharger la figure on n'a représenté qu'une partie des enroulements primaires. On remarque que ces enroulements primaires sont bobinés à l'extérieur de l'enroulement secondaire 57 rappelé par un parallélépipède en tirets. On distingue sur cette figure un enroulement primaire 58, parcouru par un courant dans le sens des flèches simples, et un enroulement primaire 59 parcouru par un courant dans le sens des flèches doubles. Les sens de ces courants sont compatibles pour produire des champs électromagnétiques de même orientation. Chacun des enroulements primaires 58 et 59 comporte trois spires. La section de ces spires de forme rectangulaire, homothétique de la forme des spires de l'enroulement secondaire 57, est liée à la forme de la section de la jambe centrale 63 du transformateur 5. D'autres formes que rectangulaires peuvent être retenues.

On remarque une particularité de réalisation de ces enroulements 58 et 59 en ce que leurs brins conducteurs de raccordement respectivement 64, 65 et 66, 67 sont rapprochés l'un de l'autre pour venir au contact des plots de distribution 68, 69 et 70. Du fait de leur proximité respective, ces brins conducteurs, parcourus par des courants égaux mais de sens inverse, engendrent des champs électromagnétiques parasites qui s'annulent mutuellement et réduisent d'autant les inductances de fuite liées à l'enroulement primaire considéré.

Une autre particularité des enroulements primaires examinés est que chacun d'eux ne s'étend que sur une partie tout du long de l'enroulement secondaire 57. On remarque ainsi que ces enroulements primaires sont bobinés de manière générale en spirale. Chaque enroulement primaire est alors réalisé dans un plan : les plans P58 et P59 (ceux-ci sont représentés par ailleurs en vue de dessus sur la figure 3B). La tranche déterminée par chaque enroulement a ainsi approximativement une épaisseur égale à la section du fil ayant servi à sa réalisation. Tels qu'ils sont alors réalisés on constate que deux enroulements consécutifs appariés, ici les enroulements 58 et 59, ne se déploient que dans trois tranches consécutives représentées par les plans P58, P59 et P60. La figure 3B présente une succession d'enroulements appariés occupant chacun trois tranches. La séparation des trois tranches est exagérée pour mieux faire comprendre. Cette façon de faire a deux conséquences importantes. Premièrement la réalisation du primaire du transformateur en devient compacte. Deuxièmement les inductances parasites apportées par les brins conducteurs de raccordement (par exemple 64 et 65) sont quasiment annihilées. En effet, sur tout leur parcours, tant sur la partie qui sépare la tranche d'enroulement P58 de la tranche de raccordement P60, que sur la partie qui sépare le dessus de la spire des plots de raccordement 70 et 68, les brins 64 et 65 parcourus par des courants égaux et de sens inverse sont parallèles et proches l'un de l'autre.

L'ensemble de ces enroulements primaires 58, 59, etc., mis mécaniquement bout à bout vient recouvrir sur toute sa longueur l'enroulement 57. Dans l'exemple retenu où le secondaire en trois nappes se déploie sur 240 : 3 = 80 spires, les 40 enroulements primaires se déploient sur (40 : 2) × 3 = 60 spires. Compte tenu des isolations nécessaires entre les tranches d'enroulements primaires, ces deux déploiements sont compatibles : le primaire recouvre le secondaire sur toute sa longueur.

Selon la disposition étudiée ici on conçoit que le fait d'avoir disposé les enroulements primaires à l'extérieur de l'enroulement secondaire 57 éloigne ces enroulements de la jambe centrale 63 du circuit magnétique ici non représentée. Ce désavantage est contrebalancé par une limitation notable des inductances de fuite et par un raccordement plus aisé de ces enroulements primaires sur les plots de distribution. En effet, les brins conducteurs de raccordement 64 et 65 évoluent en espace libre jusqu'à ces plots et n'ont pas à traverser la nappe, voire la triple nappe, constituée par l'enroulement secondaire 57.

Cependant la réalisation du primaire en deux nappes, ou même en plusieurs, est également envisageable. On voit clairement sur la figure 3C, où les enroulements primaires sont bobinés conventionnellement, que l'espace disponible entre les brins 64, 65 et 66, 67 est susceptible de permettre la réalisation d'une autre nappe extérieure à la nappe représentée. Dans cette variante les brins conducteurs de raccordement sont également rapprochés.

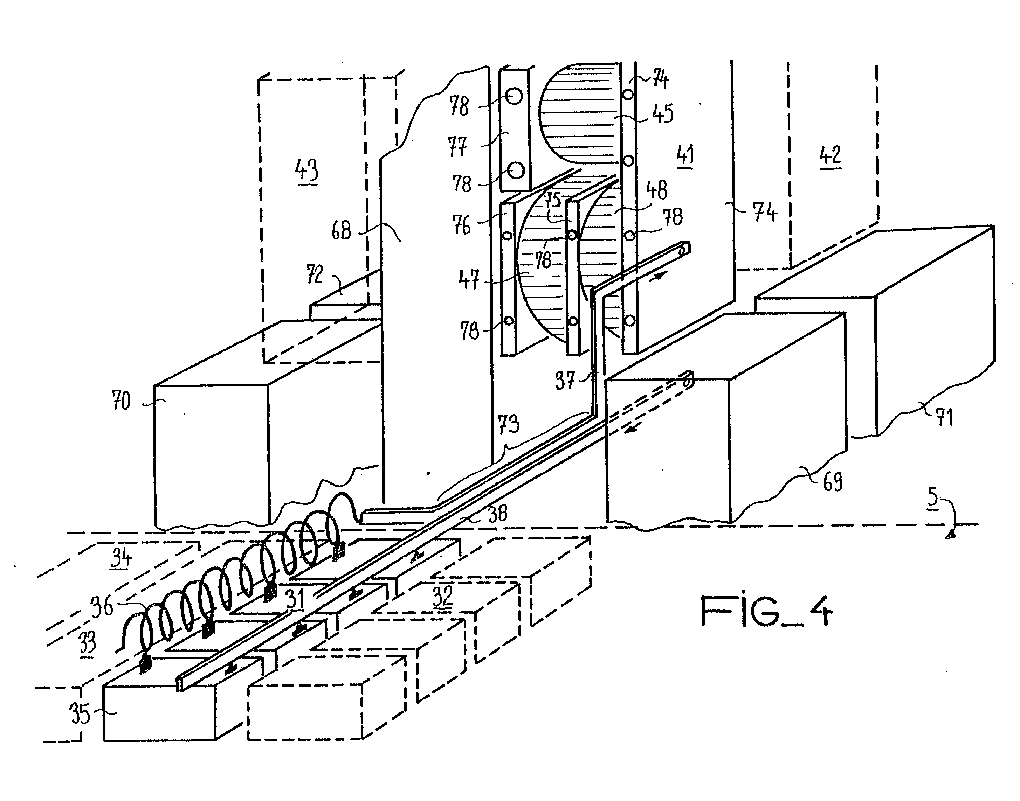

Sur la figure 4 on distingue l'ensemble du modulateur de l'invention comprenant notamment au moins une ligne à retard 31 pour alimenter un commutateur d'impulsions 41. Ces impulsions sont appliquées aux enroulements primaires du transformateur 5 par les plots de distribution 68 et 69 qui plongent dans ce transformateur. Cette représentation permet d'appréhender les positions relatives des lignes à retard 31, 32, 33 et 34 ainsi que celles des commutateurs d'impulsions 41, 42, 43 le commutateur d'impulsions 44 n'étant pas représenté. Dans cette vue en perspective, la jambe centrale non visible du circuit magnétique du transformateur 5 est disposé sous le plot de distribution 68 dans l'alignement de la barre de raccordement 38.

Cette figure 4 permet de remarquer deux particularités du montage. Premièrement les barres conductrices de raccordement 37 et 38, assurant la liaison de la ligne à retard 31 au commutateur d'impulsions 41, empruntent sur la plus grande partie de leur parcours noté 73 des chemins rapprochés. Sur le plan pratique ces deux barres sont presque collées l'une contre l'autre et ne sont séparées que par un film isolant. Cette disposition a pour objet d'éviter la création d'une inductance parasite en sortie de la ligne à retard ce qui reviendrait à la désadapter. Cette disposition introduit une capacité parasite du fait de la proximité des deux barres 37 et 38, mais la présence de cette capacité parasite est sans inconvénient. Le souci de réduire les inductances parasites de la ligne à retard est lié au besoin de réduire leurs effets qui sont d'autant plus importants que le courant qui les traverse est plus élevé, ce qui est le cas ici.

Le thyristor 45, la diode 47, et la résistance 48, tous d'un type cylindrique, sont reliés entre la barre de raccordement 37 et le plot de distribution 68 par un jeu de plaques conductrices 74 à 77. Ces plaques sont pressées par des moyens mécaniques non figurés contre le plot de distribution 68. La particularité de ces plaques conductrices est qu'elles sont creuses et qu'elles sont munies d'orifices 78 permettant le passage d'un fluide de refroidissement isolant. On remarque enfin que dans un souci de réduire les inductances de fuite les longueurs des contacts ont été réduites au minimum donnant ainsi à l'ensemble un aspect compact.

Cette figure indique deuxièmement comment sont disposés les différents plots de distribution 68 à 72. Alors que le plot 68, appelé plot chaud, commun à l'un des brins de tous les enroulements primaires, est disposé transversalement au centre du transformateur 5, les plots dits froids, 69 à 72, sont disposés en deux alignements de part et d'autre de ce plot chaud, respectivement les alignements 69, 71 et 70, 72. Cette disposition est à rapprocher pour mieux comprendre de la disposition des plots sur les figures 3A et 3C. On remarquera enfin la disposition continue des enroulements 36 dont certaines parties de spires viennent au contact de l'une des bornes des capacités 35 réduisant ainsi simplement la liaison entre ces inductances et ces capacités.

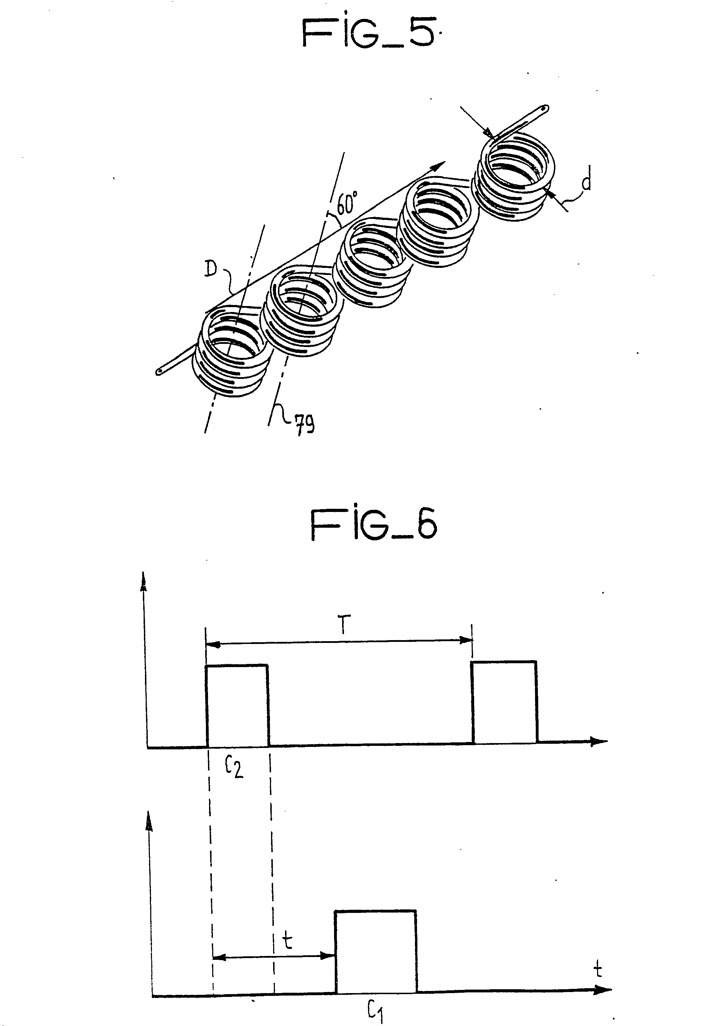

La figure 5 présente une réalisation particulière des inductances 36 des lignes à retard. Ces inductances 36 sont formées d'un certain nombre de spires, dans l'exemple 4 spires mises côte à côte. Les axes de bobinage de ces groupements de spires, tous parallèles à l'axe de bobinage 79 de l'un d'entre eux sont inclinés par rapport à l'alignement D de ces inductances 36 d'un angle de 60° environ. On peut démontrer que cet angle est de nature à assurer le meilleur découplage des inductances 36 entre elles. Une deuxième particularité de ces bobinages est que le diamètre d des spires va croissant de l'extrémité gauche de la figure à l'extrémité droite. L'extrémité droite est l'extrémité la plus proche du transformateur 5. La variation de diamètre est de l'ordre de 10 %. Dans un exemple ces diamètres passent de 8,6 cm à 9 cm. La raison de cette croissance réside dans la nécessité de contrecarrer l'effet de prémagnétisation du transformateur qui aurait pour résultat de délivrer, en sortie de ce transformateur, une impulsion dont le plat présenterait, du début à la fin, une légère décroissance.

Sur la figure 6 enfin apparaissent les diagrammes temporels d'application des impulsions de commande C1 et C2 respectivement aux thyristors 26 et 45. L'impulsion de décharge C2 des lignes à retard est appliquée périodiquement avec une période T. Dans l'exemple décrit, T vaut 20 millisecondes et correspond à une fréquence de récurrence de 50 Hertz. L'impulsion de commande C1, appliquée selon une même période que l'impulsion C2, est retardée d'une durée t par rapport à celle-ci pour permettre une désionisation efficace du thyristor 45 en fin de décharge. Elle n'autorise la recharge de la ligne à retard que lorsque les thyristors 45 sont de nouveau bloqués. Cette durée t est ajustée expérimentalement, dans un exemple elle vaut 2 millisecondes.

Dans l'application décrite, l'impulsion introduite aux primaires du transformateur a pour amplitude 500 volts ; la somme des courants qui parcourent les divers enroulements primaires est égale à 13 000 ampères ; la durée de cette impulsion est de l'ordre de 300 microsecondes. Dans ces conditions l'impulsion disponible au secondaire 57 a une amplitude de 40 kilovolts et le courant disponible vaut 150 ampères. Ces valeurs sont du même ordre que celles usuellement retenues pour alimenter en tension un tube triode haute fréquence excitant électromagnétiquement les cavités d'un accélérateur linéaire. Il est à noter que cette application n'est pas la seule envisageable en particulier dans le domaine des radars l'excitation des magnétrons ou klystrons peut également être réalisée avec un tel modulateur.

## Revendications

1. Modulateur de puissance muni d'un transformateur (5) pour recevoir des impulsions électriques élaborées par un étage (2-3-4) générateur d'impulsions et pour produire des impulsions électriques de tension plus élevée, ledit transformateur étant du type cuirassé et comportant un certain nombre d'enroulements primaires (51, 52, 53, 54) raccordés en parallèle à l'étage générateur d'impulsions, ces enroulements primaires étant bobinés autour de l'enroulement secondaire (57) de ce transformateur, caractérisé en ce que les enroulements primaires sont raccordés à des plots de distribution (68 à 72) par des brins conducteurs (64, 65) rapprochés pour réduire les pertes inductives.

2. Modulateur selon la revendication 1 caractérisé en ce que l'étage générateur d'impulsions comporte au moins une ligne à retard (31) reliée à un commutateur d'impulsions (41).

3. Modulateur selon la revendication 1 ou la revendication 2 caractérisé en ce que le rapport de transformation du transformateur est supérieur à 40.

4. Modulateur selon l'une quelconque des revendications 1 à 3 caractérisé en ce que chaque enroulement primaire est réalisé en forme générale de spirale selon une tranche et en ce que toutes les tranches sont accolées pour se déployer sur la longueur de l'enroulement secondaire.

5. Modulateur selon l'une quelconque des revendications 1 à 4 caractérisé en ce que les enroulements primaires sont réalisés en une seule nappe cylindrique commune à tous ces enroulements, ladite nappe entourant l'enroulement secondaire.

6. Modulateur selon la revendication 2 caractérisé en ce que les enroulements primaires sont groupés en m groupes, chacun des deux brins conducteurs (64, 65) de raccordement d'un enroulement primaire d'un groupe étant connecté d'une part à un plot chaud (68) commun à tous les groupes et d'autre part à un plot froid (70) particulier à ce groupe.

7. Modulateur selon la revendication 6 caractérisé en ce que le nombre d'enroulements primaires vaut 40 et en ce que le nombre m de groupes vaut 4.

8. Modulateur selon l'une quelconque des revendications 6 à 7 caractérisé en ce qu'il comporte m lignes à retard (31 à 34) reliées à m commutateurs d'impulsions (41 à 44) et en ce que chacun des m commutateurs d'impulsions est relié en parallèle d'une part sur le plot chaud (68) commun et d'autre part sur le plot froid (69 à 72) d'un groupe.

9. Modulateur selon la revendication 2 caractérisé en ce que les lignes à retard comportent une succession de demi-cellules formées de capacités (35) et d'inductances (36) lesdites inductances étant formées d'un nombre constant de spires dont le diamètre (d) va croissant d'une extrémité à l'autre de la ligne selon que l'on se rapproche du transformateur.

10. Modulateur selon l'une quelconque des revendications 2 ou 9 caractérisé en ce que les lignes à retard comportent une succession de demi-cellules, formées de capacités et d'inductances alignées selon une direction (D) et en ce que lesdites inductances sont formées de spires dont les axes (79) de bobinage, sensiblement parallèles, sont inclinés par rapport à la direction de la ligne à retard d'un angle de 60° environ.

11. Modulateur selon l'une quelconque des revendications 2 ou 9 à 10 caractérisé en ce que les bornes de sortie de chaque ligne à retard sont connectées aux commutateurs d'impulsions par des conducteurs de sortie (37, 38) proches (73) l'un de l'autre.

12. Utilisation d'un modulateur selon l'une quelconque des revendications 1 à 11 dans un accélérateur linéaire.

## Claims

1. Power modulator provided with a transformer (5) for receiving electric pulses generated by a pulse generator stage (2-3-4) and for producing electric pulses of higher voltage, said transformer being of the enclosed type and comprising a certain number of primary windings (51, 52, 53, 54) connected in parallel to the pulse generator stage, these primary windings being wound about the secondary winding (57) of this transformer, characterized in that the primary windings are connected to distribution tabs (68 to 72) by conductive strands (64, 65) located close to each other for reducing the inductive losses.

2. Modulator according to claim 1, characterized in that the pulse generator stage comprises at least one delay line (31) connected to a pulse switch (41).

3. Modulator according to claim 1 or claim 2, characterized in that the transformation ratio of the transformer exceeds 40.

4. Modulator according to any of claims 1 to 3, characterized in that each primary winding is generally spirally provided along a section and in that all of the sections are joined to extend themselves along the length of the secondary winding.

5. Modulator according to any of claims 1 to 4, characterized in that the primary windings are embodied as a single cylindrical layer in common to all of these windings, said layer surrounding the secondary winding.

6. Modulator according to claim 2, characterized in that the primary windings are grouped into m groups, each of the conductive strands (64, 65) for connecting a primary winding of one group being connected, on the one hand, to one hot tab (68) which is common to all of the groups and, on the other hand, to a cold tab (70) which is particular to this group.

7. Modulator according to claim 6, characterized in that the number of primary windings is 40 and in that the number m of groups is 4.

8. Modulator according to any of claims 6 and 7, characterized in that in comprises m delay lines (31 to 34) connected to m pulse switches (41 to 44), and in that each of the m pulse switches is connected in parallel, on the one hand, to the common hot tab (68) and, on the other hand, to the cold tab (69 to 72) of one group.

9. Modulator according to claim 2, characterized in that the delay lines comprise a succession of half-cells formed of capacities (35) and inductances (36), said inductances being formed of a constant number of turns the diameter (d) of which increases from one end of the line to the other as one approaches the transformer.

10. Modulator according to any of claims 2 or 9, characterized in that the delay lines comprise a succession of half-cells formed of capacities and inductances aligned along a direction (D), and in that said inductances are formed of turns the winding axes (79) of which are substantially parallel and inclined with respect to the direction of the delay line by an angle of substantially 60°.

11. Modulator according to any of claims 2 or 9 to 10, characterized in that the output terminals of each delay line are connected to the pulse switches by output conductors (37, 38) lying close (73) to each other.

12. Use of a modulator according to any of claims 1 to 11 in a linear accelerator.

## Patentansprüche

1. Leistungsmodulator, der mit einem Transformator (5) versehen ist, um elektrische Impulse zu empfangen, die durch eine Impulsgeneratorstufe (2-3-4) erzeugt werden, und um höhere elektrische Spannungsimpulse zu erzeugen, wobei der genannte Transformator vom gekapselten Typ ist und eine bestimmte Anzahl von Primärwicklungen (51, 52, 53, 54) aufweist, die parallel an die Impulsgeneratorstufe angeschlossen sind, wobei diese Primärwicklungen um die Sekundärwicklung (57) dieses Transformators aufgebracht sind, dadurch gekennzeichnet, daß die Primärwicklungen an Verteilerklötzchen (68 bis 72) über nahe beieinanderliegende Leiterlitzen (64, 65) zur Verminderung der induktiven Verluste angeschlossen sind.

2. Modulator nach Anspruch 1, dadurch gekennzeichnet, daß die Impulsgeneratorstufe wenigstens eine Verzögerungsleitung (31) umfaßt, die an einen Impulsschalter (41) angeschlossen ist.

3. Modulator nach Anspruch 1 oder Anspruch 2, dadurch gekennzeichnet, daß das Übersetzungsverhältnis des Transformators größer als 40 ist.

4. Modulator nach einem der Ansprüche 1 bis 3, dadurch gekennzeichnet, daß jede Primärwicklung in der allgemeinen Form einer Spirale gemäß einem Abschnitt verwirklicht ist und daß alle Abschnitte nebeneinandergefügt sind, um sich über die Länge der Sekundärwicklung zu erstrecken.

5. Modulator nach einem der Ansprüche 1 bis 4, dadurch gekennzeichnet, daß die Primärwicklungen aus einer einzigen zylindrischen Lage gebildet sind, die allen Wicklungen gemeinsam ist, wobei die genannte Lage die Sekundärwicklung umgibt.

6. Modulator nach Anspruch 2, dadurch gekennzeichnet, daß die Primärwicklungen in m-Gruppen gruppiert sind, wobei jede der zwei Leiterlitzen (64, 65) zum Anschließen einer Primärwicklung einer Gruppe einerseits an ein heißes Klötzchen (68), das allen Gruppen gemeinsam ist, und andererseits an ein kaltes Klötzchen (70), das besonders zu dieser Gruppe gehört, angeschlossen ist.

7. Modulator nach Anspruch 6, dadurch gekennzeichnet, daß die Anzahl von Primärwicklungen 40 beträgt und daß die Anzahl m von Gruppen 4 beträgt.

8. Modulator nach einem der Ansprüche 6 bis 7, dadurch gekennzeichnet, daß er m Verzögerungsleitungen (31 bis 34) enthält, welche mit m Impulsschaltern (41 bis 44) verbunden sind, und daß jeder der m Impulsschalter parallel einerseits an das heiße gemeinsame Klötzchen (68) und andererseits and das kalte Klötzchen (69 bis 72) einer Gruppe angeschlossen ist.

9. Modulator nach Anspruch 2, dadurch gekennzeichnet, daß die Verzögerungsleitungen eine Aufeinanderfolge von Halbzellen umfassen, die aus Kapazitäten (35) und Induktivitäten (36) gebildet sind, wobei die genannten Induktivitäten aus einer konstanten Anzahl von Windungen gebildet sind, deren Durchmesser (d) von einem Ende der Leitung zum anderen mit zunehmender Annäherung an den Transformator zunimmt.

10. Modulator nach einem der Ansprüche 2 oder 9, dadurch gekennzeichnet, daß die Verzögerungsleitungen eine Aufeinanderfolge von Halbzellen umfassen, die aus Kapazitäten und Induktivitäten gebildet sind, welche in einer Richtung (D) ausgerichtet sind, und daß die genannten Induktivitäten durch Windungen gebildet sind, deren Wicklungsachsen (79), die im wesentlichen parallel sind, gegenüber der Richtung der Verzögerungsleitung um einen Winkel von etwa 60° geneigt sind.

11. Modulator nach einem der Ansprüche 2 oder 9 bis 10, dadurch gekennzeichnet, daß die Ausgangsanschlüsse jeder Verzögerungsleitung an die Impulsschalter über Ausgangsleiter (37, 38) angeschlossen sind, die nahe beieinander liegen (73).

12. Verwendung eines Modulators nach einem der Ansprüche 1 bis 11 in einem Linearbeschleuniger.

FIG_1

0 125 948

# FIG_2

# FIG_3-A

## FIG_3-B

58 59

65
64
66
67

P58  P60  P59

## FIG_3-C

68
70  69

64
65  66
67

59
51
57
58

3

FIG_4

0 125 948

# FIG_5

# FIG_6